# EUROPEAN PATENT APPLICATION

(11) **EP 0 827 220 A2**
(43) Date of publication of application: **04.03.1998**
(21) Application number: 97114191.6
(22) Date of filing: 18.08.1997
(51) Int. Cl.: H01L 43/10, G11B 5/39

(54) **Methods and compositions for optimizing interfacial properties of transducers used in data storage devices**

(30) Priority: 26.08.1996 US 702977
(71) Applicant: READ-RITE CORPORATION, Milpitas California 95035 (US)
(72) Inventor: Nepela, Daniel A., San Jose, California 95123 (US)
(74) Representative: Körber, Wolfhart, Dr. rer.nat.

(57) **Abstract**

A method for maximizing the interfacial properties of sensors (10), such as spin valve and GMR sensors (10), used in storage devices, comprises selecting the materials for ferromagnetic layers (FM1, FM2) and for electrically conductive spacers (12) that are interposed between the ferromagnetic layers (FM1, FM2). The electronegativities of the selected materials are substantially matched so that the differences in electronegativities is minimized. The conductive spacer (12) material provides a relatively low resistivity and/or a large mean free path. The sensors (10) experience greater chemical and thermal stability, are corrosion resistant, and realize an increased signal output.

## Description

### Field of the Invention

This invention relates to methods and compositions for optimizing the interfacial properties of data storage devices, such as spin valve sensors and giant magnetoresitance (GMR) sensors.

### Description of the Prior Art

Significant progress has occurred over the past two decades in the design of multilayered nanostructured thin film systems. The prior art describes large GMR current-in-plane (CIP) effects in an Fe/Cr multilayered system, approximating a GMR effect (%ΔR/R) of 100%, that is change by a factor of two in resistance with an adequate external field. Since then, many other multilayer GMR and spin valve sensors have been explored. To date, the highest GMR effect is in the Fe/Cr system and is approximately 150% at a measurement temperature of 5°K, and remains the largest value observed at any temperature to date. The GMR effect is characterized by %ΔR/R, which is defined as the change in resistance divided by the initial resistance, and is
100 (R₀-R_{H})/R₀, where R₀ is without an external magnetic field and R_{H} is at maximun external field.

Numerous theoretical studies have attempted to explain the behavior of spin valve and GMR effects, and thus far there does not exist a uniform, universally accepted explanation of the main factors controlling the magnitude of the response as characterized by %ΔR/R. On the experimental side, efforts have been largely based on trial and error, by experimenting with various combinations of ferromagnetic layers and conductive spacer layers. None of the previous work has yielded quantitative guidelines for the maximization of %ΔR/R for spin valve or GMR sensors by providing selection criteria for the proper layer compositions of the ferromagnetic material and the conductive spacer.

### Summary of the Invention

An object of this invention is to provide means and methods for optimizing the manufacturing process of various devices, including but not limited to thin film devices such as sensors used in data storage devices.

Another object of this invention is to provide quantitative guidelines for optimizing the selection of multi-layer compositions by matching or minimizing the difference in the interfacial electronegativities of adjacent ferromagnetic layersand conductive spacers.

Still another object of the present invention is to maximize the signal output, as represented by %ΔR/R of spin valve sensors and giant magnetoresistance (GMR) sensors.

A further object of this invention is to maximize the thermal stability of spin valve sensors and giant magnetoresistance sensors.

Yet another object of this invention is to maximize the corrosion resistance of spin valve sensors and giant magnetoresistance sensors.

Another object is to provide for multiple interfacial matching of a ferromagnetic layer with its contacting conductive spacers.
In accordance with this invention, spin valve sensors and GMR sensors are made with layers of ferromagnetic (FM) material and conductive spacers interposed between the FM layers. The difference in electronegativities between the layers and spacers is minimized. A relatively low resistivity and/or a large mean free path is provided by the conductive spacer material. As a result of these conditions, the %ΔR/R of the sensor is maximized. The novel sensor is corrosion resistant, and experiences greater chemical and thermal stability, and signal output of the sensor device is increased.

a method for optimizing the interfacial properties of a data storage device. The inventive method includes selecting one or more electrically conductive spacers having at least a first electronegativity (χ spacer), and selecting one or more FM layers having at least a second electronegativity (χ FM), such that the selecting steps include the step of substantially matching the first and second electronegativities and minimizing the difference between the electronegativities.

### Brief Description of the Drawing

The invention will be described in greater detail with reference to the drawing in which:
Fig. 1 is a diagrammatic cross-sectional view depicting a spin valve sensor made in accordance with this invention;
Fig. 2 is a diagrammatic cross-sectional view depicting a GMR sensor made in accordance with this invention;
Fig. 3 is a graph plotting the relationship of the electronegativity difference (|Δχ|^{1/2}) versus %ΔR/R for spin valve sensors with different ferromagnet/conductive spacer interfaces;
Fig 4 illustrates three graphs plotting the relationship of the electronegativity difference (|Δχ|^{1/2}) versus %ΔR/R for Co, NiFe, Ni spin valve sensors with a constant thickness copper spacer of approximately 60A;
Fig. 5 illustrates three graphs plotting the relationship of the electronegativity difference (|Δχ|^{1/2}) versus %ΔR/R for various CoNi alloys including Co and Ni as FM layers illustrating the first, second and third peaks of GMR response;
Fig. 6 illustrates three graphs plotting the relationship of the electronegativity difference (|Δχ|^{1/2}) versus %ΔR/R for various FM/conductive spacer interfaces including CoCr, CoCu and CoAg as FM layers for the first, second and third peaks of GMR response;
Fig. 7 is a chart that graphically illustrates various exemplary combinations and compositions of FM layers and spacers for use in spin valve and GMR sensors;
Fig. 8 illustrates two graphs plotting the electrical resistivity in microOhm-cm versus the atomic composition for a Cu-Au superlattice system;
Fig. 9 illustrates two graphs plotting the electrical resistivity in microOhm-cm versus the atomic composition for a CuPt superlattice system;
Fig. 10 illustrates the use of single crystal orientation in a spin valve sensor made according to the present invention;
Fig. 11 illustrates the use of polycrystalline randon orientation in a spin valve sensor made according to the present invention;
Fig. 12 is a cross-sectional view of a spin valve sensor with compound interfaces made according to the present invention; and
Fig. 13 is a cross-sectional view of a giant magnetoresistance sensor with compound interfaces made according to the present invention.

Similar numerals refer to similar elements in the drawing. It should be understood that the sizes of the different components in the figures are not necessarily in exact proportion, and are shown for visual clarity and for the purpose of explanation.

### Detailed Description of the Invention

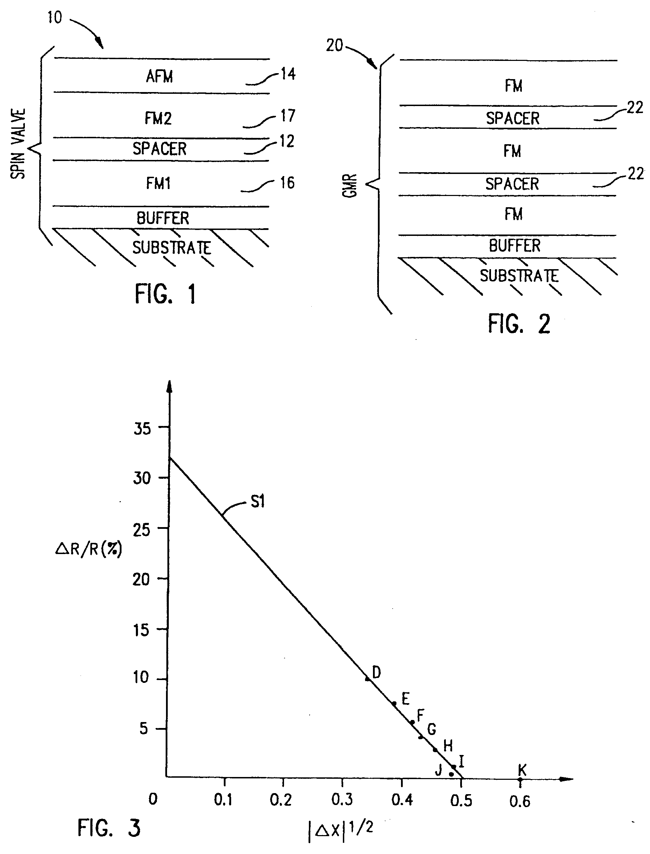

Fig. 1 is a partial cross-section reprresenting a spin valve magnetoresistive (MR) sensor 10 made according to the present invention. The spin valve sensor 10 is formed of two FM layers FM1, FM2 that are separated by a conductive spacer or layer 12. The sensor 10 is formed on a nonmagnetic substrate on which a buffer layer, about 25-100 Angstroms thick, is deposited. The buffer layer is made from Ta, Cr, Fe, Pt, Pd, Ir or Au. The FM layers FM1 and FM2 may have the same or different composition. The magnetization of the FM layer FM2 is pinned by placing it in atomic contact with an antiferromagnetic (AFM) layer 14, such as an iron-manganese (FMn) layer. The magnetization of the unpinned FM layer FM1 is free to rotate in the presence of an external magnetic field.

The application of an external magnetic field causes a variation in the magnetization orientation of the FM layer FM1, which causes a change in the spin-dependent scattering of conduction electrons and thus in the electrical resistance of the spin valve sensor 10. The resistance of the spin valve sensor 10 changes as the relative alignment of the magnetization of the FM1 layer changes. The FM2 layer remains constrained and its magnetization direction renmains the same.

The present invention proposes an empirical relationship between %ΔR/R and the electronegativity difference between adjacent FM layers and conductive spacers in spin valve and GMR sensors. Such a general empirical relationship applies to both spin valve and GMR sensors, and shows that %ΔR/R response is a function of the electronegativity mismatch between adjacent FM layers and conductive spacers. It is applicant's belief that the mismatch in electronegativities (χ)ₛ results in a potential barrier at the interface that is related to the absolute value of the difference in the electronegativities of the FM layers and the conductive spacers, i.e.,Δχ. With increasing Δχ mismatch, the %ΔR/R amplitude of the spin valve and GMR sensors will decrease to a point where %ΔR/R will approach an intercept value of zero. As shown later, this intercept value uniformly occurs at a value of |Δχ|^{1/2} ≅ 0.5 for both spin valve and GMR sensors indicating that the underlying mechanism for obtaining %ΔR/R is the same for both types of sensors.

It is shown that the percent ionic content of an interface A/B between a ferromagnet A and a conductive spacer B can be estimated by the electronegativity difference between the ferromagnet A and the spacer B. By applying the foregoing empirical finding that |Δχ|^{1/2} ≅ 0.5 when %ΔR/R approaches zero, it is possible to estimate the percent ionic content of the interface A-B as follows:${\text{%Ionic Content = 1-e-1/4(x}}_{\text{A}} {\text{-x}}_{\text{B}} \text{))2}$

For ${\text{|χA-χB|}}^{\text{1/2}} {\text{= |Δχ|}}^{\text{1/2}} \text{= 0.5}$ the ionic content at the interface A-B is approximately 1.5%. Additionally, at the intercept point where %ΔR/R approaches zero, the excess ionic energy at the interface can be estimated and the excess ionic energy at the interface equal to 1.96 Kcal or 0.085 eV.

By an appropriate selective matching of the electronegativities (χ's) of the spacer 12 and the adjacent FM layers FM1, FM2, it is possible to maximize the magnetoresistive response (as characterized by %ΔR/R), and thus the signal output of the spin valve sensor 10 is maximized.

The important inventive concept has been the development of the following relationships illustrated by equations (1) and (2):$\begin{matrix}\begin{matrix}\begin{matrix}\text{|Δχ| = χ (FM) - χ (spacer) ≈ o,}\end{matrix} \\ \begin{matrix}\text{where: χ (spacer) = 0.44 Ø(spacer) - 0.15, and}\end{matrix} \\ \begin{matrix}\text{χ (FM) = 0.44 φ (FM) - 0.15,}\end{matrix}\end{matrix}\end{matrix}$ where χ(FM) represents the electronegativity of the FM layers; χ(spacer) represents the electronegativity of the spacer 12; and where Ø(spacer) and Ø(FM) are the work functions of the spacer 12 and FM layers, respectively.

Each chemical element has a work function Ø from which the χ of that element is computed by either equations (1a) or (1b) that are equivalent. For alloys containing additional elements that constitute either the FM material or the conductive spacer used in the GMR or spin valve sensors, the χ of such alloys has been found to be an additive property of the constituents of the alloy, so that the χ of the alloy is the sum of the products of the atomic fraction of any element in the alloy times the electronegativity of that element summed over all elements constituting the alloy, as expressed in equation (2).${\text{χ}}_{\text{(alloy a-b-c)}} {\text{= f}}_{\text{a}} {\text{χ}}_{\text{a}} {\text{+ f}}_{\text{b}} {\text{χ}}_{\text{b}} {\text{+ f}}_{\text{c}} {\text{χ}}_{\text{c}} \text{,}$ where fₐ, f_{b}, and f_{c} refer to the atomic fraction of elements a, b and c, respectively forming the alloy; and χₐ, χ_{b} and χ_{c} refer to the electronegativities of elements a, b and c, constituting the alloy. While only a ternary alloy has been considered for illustration purpose, it should be understood that equation (2) is applicable to alloys with any number of elements. In addition, equation (2) applies both to ferromagnets and conductors.

Fig. 2 illustrates the use of the present inventive concept in a giant magnetoresistive (GMR) sensor 20. The GMR sensor 20 is a sandwich structure formed of a plurality of layers, such as FM, that are separated by a plurality of conductive spacers 22. Although not shown in Fig. 2, the FM/spacer structure can have a multiplicity of 5 to 75 repeat units of FM/spacers. In the GMR sensor 20 the electronegativities of each of the successive layers FM are substantially matched or their difference in χ is minimized with the electronegativity of the contiguous spacers 22.

Prior art methods for fabricating spin valve and GMR sensors included combining spacers made of an adequately electrically conductive material such as Au, Ag or Cu, with layers of FM materials such as FeCo alloy or NiFe alloy, or elements Fe, Co and Ni, without regard to the electronegativity matching between the successive FM layers and conductive spacers. These prior art methods are mainly based on trial and error studies.

The following Tables I and II provide listings of some exemplary conductors and ferromagnets, in the face centered cubic (FCC) and body centered cubic (BCC) systems, respectively, that could be used to fabricate various devices, including but not limited to spin valve and GMR sensors, based on the electronegativity matching or minimizing process of the present invention.

**TABLE 1**

| FCC SYSTEMS | | | |
|---|---|---|---|
| CONDUCTOR | χ(CONDUCTOR) | FERROMAGNET | χ(FERROMAGNET) |
| Cu | 1.91 | NiFe(80:20) | 2.095 |
| Ag | 1.89 | Ni₃Fe | 2.08 |
| Au | 2.22 | Ni₃Mn | 2.02 |
| Pt | 2.34 | Fe₄Mn | 2.13 |
| Pd | 2.32 | FePd | 2.12 |
| Cu₃Pt | 2.02 | *Fe_{1-y} Au_{y} | 2.0 ≤ χ _ 2.13 |
| CuPt | 2.13 | **Co_{1-z} Au₂ | 2.07 ≤ χ ≤ 2.14 |
| Cu₃Au | 1.99 | CuAu | 2.07 |
| Cu₃Pd | 2.00 | | |
| CuPd | 2.06 | | |

| | | | |
|---|---|---|---|
| * Where y is the atomic fraction with a value between 0.30 and 0.70; and | | | |
| ** where z is the atomic fraction with a value between 0.10 and 0.50. | | | |

**TABLE II**

| BCC SYSTEMS | | | |
|---|---|---|---|
| CONDUCTOR | χ(CONDUCTOR) | FERROMAGNET | χ(FERROMAGNET) |
| Cr | 1.83 | *Fe_{1-µ} Cr_{µ} | 1.85 ≤ χ ≤ 1.88 |
| Cr | 1.83 | **Fe_{1-w} V_{w} | 1.85 ≤ χ ≤ 1.87 |
| Cr | 1.83 | Ternary FeCrV systems | 1.84 _ χ_ 1.87 |

| | | | |
|---|---|---|---|
| *Where u is the atomic fraction with a value between 0.40 and 0.70, and | | | |
| **where w is the atomic fraction with a value between 0.25 and 0.35. | | | |

### Example 1

In Table I above, the electronegativities of the conductors and the ferromagnets represent the atomic fraction weighted electronegativities, as illustrated by the following example for Cu₃Pt:${\text{χ(Cu}}_{\text{3}} {\text{Pt) = {}}^{\text{∼}} {\text{0.75}}^{\text{∼}} {\text{χ(Cu)}}^{\text{∼}} {\text{+}}^{\text{∼}} {\text{0.25χ(Pt)}}^{\text{∼}} {\text{} =}}^{\text{∼}} {\text{2.02}}^{\text{∼}} \text{,}$ where χ(Cu₃Pt) is the electronegativity of Cu₃Pt; χ(Cu) = 1.91; and χ(Pt) = 2.34. This example illustrates that the atomic fraction of the electronegativities (χ's) of the elements of any alloy conductor or ferromagnet formed of any number of elements, i.e., ternary, quaternary, etc., can be used to calculate the electronegativity of the alloy.

By using Table I above, it is possible to closely match the electronegativities of the conductors and the ferromagnets. For example, having selected Cu₃Pt as the conductor of choice, it would be desirable to select a FM material having a close electronegativity. Table I indicates that one of the closest materials whose electronegativity matches that of Cu₃Pt is NiMn, since the average electronegativity of Ni₃Mn is 2.02 and Δχ^{∼}0

### Example 2

Ni₃Mn, a superlattice intermetallic compound having an electronegativity of 2.02 may be matched with Cu₃Pt. The matching of two superlattice structures is desirable in that these ordered structures will improve the thermal stability of the device containing them, since additional external thermal energy would be required to disorder one or both superlattice structures before the elements contained in superlattice were free to diffuse at the interface. This additional energy ranges between 0.1 eV to 0.3 eV above the activation energy for cross diffusion at the interface between the conductor spacer and the FM layer.

### Example 3

A subsequent inquiry may then be whether there exists another ferromagnet with other desirable characteristics, such as minimal magnetostriction (λs), higher corrosion resistance, and/or lower resistivity than Ni₃Mn. Ni₃Fe, also a superlattice alloy, with an electronegativity of 2.08, may in certain applications present a more desirable match than Ni₃Mn, due to low H_{c}, low magnetostriction and superior corrosion resistance and may be matched with a CuAu superlattice with a χ = 2.07.

### Example 4

The following is a list of conductive spacer alloys useful for the matching or minimizing the Δχ values between the spacer alloys and appropriate ferromagnetic elements or alloys thereof.

In addition to CuAu and CuPt, superlattice alloys referred to previously, the following binary ternary or higher order alloys of the elements Cu, Ag,Au, Pt, Pd, Ir, Rh and Ru may be used to match appropriate FMs and provide χ values ranging from ^{∼} 1.89 to 2.33. Such alloys may be used to fabricate various devices, including but not limited to spin valve and GMR sensors, based on the electronegativity matching or minimizing of the differences in electronegativities of the present invention.

It should be understood that other superlattice alloys similar to CuPt and CuAn superlattice structures, such as Ag₃Pt and AgPt, may be used for implementing this invention. In most applications it would be desirable for the alloys to have a bulk resistivity less than, or equal to approximately 20 µΩ cm for any spacer substitutional alloy or superlattice alloy.

### Example 5

A subsequent inquiry may then be whether the crystallographic structures of the adjacent conductive spacer and the FM layer are matched. It would be desirable to match the crystallographic structures of adjacent layers. The following is a list of additional intermetallic compounds having a face centered cubic (FCC) crystallographic structure:

| | χ |
|---|---|
| AgPt₃ | 2.23 |
| Crlr₃ | 2.20 |
| Al₂Cu | 1.79 |
| Cr₂Pt | 2.00 |
| AlCu₃ | 1.87 |

The following is a list of additional conductive spacer elements having a base centered cubic (BCC) crystallographic structure:

| | χ | χ | χ | | |
|---|---|---|---|---|---|
| Cr | 1.83 | V | 1.74 | Mo | 1.83 |
| W | 1.80 | Nb | 1.74 | Ta | 1.67 |

The following is an example confirming the desirability of matching the crystallographic structures of adjacent FM/spacer layers. Even though the electronegativity of Fe [χ(Fe) = 1.91] closely matches the electronegativity of Ag [χ(Ag) = 1.89], the resulting %ΔR/R of the FeAg is small because of the Fe and Ag lattice dissimilarities and attendant potential barriers accruing therefrom. In other terms, Fe has a BCC structure, while Ag has an FCC structure.

### Example 6

The foregoing inventive principles and examples are applicable at room temperature as well as other temperatures, such as cryogenic temperatures, i.e., 5 °K. Fe having a BCC structure and an electronegativity of 1.91, and Cr having a BCC structure as well and an electronegativity of 1.83 results in a record %ΔR/R. The electronegativity mismatch is the smallest observed to date, ^{∼}i.e.0.08 and accordingly the present invention enables the realization of record %ΔR/R (approximately 150%) at a 5°Kelvin measurement temperature. The record %ΔR/R results from the smallest Δχ experimentally produced to date.

Fig. 3 graphically illustrates the linear relationship between the magnetoresistive response as characterized by %ΔR/R of the spin valve sensor 10, relative to the square root of the absolute value of the electronegativity difference |Δχ|½ of the FM layers FM1, FM2 and the spacer 12, at room temperature, for a coupling field less than or equal to 10 Oersteds. This linear relationship is represented by a curve S1. It holds true for various spin valve layer compositions, and may be expressed generally by the following equation (3):$\text{(3) %ΔR/R ≅ A - B (|Δχ|)½,}$ where A and B are constant values.

It is generally recognized in the literature, for instance, Deny, "Giant Magnetoreristance in Spin-Valve Multilayers", Journal of Magnetism and Magnetic Materials, 136 (1994) 335-359 that a certain degree of roughness at the interface between the FM layers and the conductive spacers produces a maximal result (%ΔR/R) for a given interface. As the roughness increases or decreases from its optimal value %ΔR/R will decrease from its optimal value. This will reflect in a change in the slope, i.e., the constant value B in equation (3) above, but will not modify the proposed general principles offered by the invention, nor will it modify the

We have determined that when spin valves and GMR sensors achieve the condition described by (|Δχ|)^{½} equal to 0.5 or greater than %ΔR/R =0, the following equation (4) related to the prior finding results in the following general relationship between %ΔR/R and |Δχ| as expressed below:$\begin{matrix}\begin{matrix}{\text{%ΔR/R ≅ A - B (|Δχ|)}}^{\text{½}} {\text{, where (|Δχ|)}}^{\text{½}} \text{= χ (FM) - χ (spacer);} \\ {\text{A ≅ B (|Δχ|)}}^{\text{½}} \text{;} \\ {\text{B ≅ 2A; and is a direct result of %ΔR/R = 0 when |Δχ|}}^{\text{½}} \text{= 0.50} \\ \begin{matrix}{\text{Thus %ΔR/R ≈ A - 2A (|Δχ|)}}^{\text{½}} {\text{= A{1 - 2 (|Δχ|)}}^{\text{½}} \text{}.}\end{matrix}\end{matrix}\end{matrix}$

In an exemplary embodiment of the spin valve sensor 10, the general equation (3) may be expressed by the following experimentally derived eq 5 for spin valves formed by a variety of interfaces equation (5):${\text{%ΔR/R = 35.20 - 70.40 (|Δχ|)}}^{\text{½}} \text{.}$

### Example 7

Point D on curve S1 represents the following composition:Co ₋ Cu - CO, where the first element (Co) is the unpinned FM layer FM1, the second element [Cu] is the conductive spacer 12, and the third element [Co] is the pinned FM layer FM2. Pursuant to equation (5), the composition of this example yields a %ΔR/R of approximately 9.5%.

### Example 8

Point E on curve S1 represents Co - Cu - NiFe, where the first element Co is the unpinned FM layer FM1, the second element Cu is the conductive spacer 12, and the third element 80Ni-20Fe is the pinned FM layer FM2. Pursuant to equation (5), the composition of this example yields a %ΔR/R of approximately 6.5%.

### Example 9

Point F on curve S1 represents [80Ni 20Fe]-[Cu]-[80Ni 20Fe], where the first element [80N-20Fe] is the unpinned FM layer FM1, the second element [Cu] is the conductive spacer 12, and the third element [80Ni 20Fe] is the pinned FM layer FM2. Pursuant to equation (5), the composition of this example yields a %ΔR/R of approximately 5%.

### Example 10

Point G on curve S1 represents Co - Au - NiFe, where the first element Co is the unpinned FM layer FM1, the second element Au is the conductive spacer 12, and the third element 80Ni-20Fe is the pinned FM layer FM2. Pursuant to equation (5), the composition of this example yields a %ΔR/R of approximately 4.5%.

### Example 11

Point H on curve S1 represents Ni- Cu -Ni, where the first element (Ni) is the unpinned FM layer FM1, the second element [Cu] is the conductive spacer 12, and the third element [Ni] is the pinned FM layer FM2. Pursuant to equation (5), the composition of this example yields a %ΔR/R of approximately 2.5%.

### Example 12

Point I on curve S1 represents [80Ni 20Fe]-[Pt]-[80Ni 20Fe], where the first element [80Ni 20Fe] is the unpinned FM layer FM1, the second element [Pt] is the conductive spacer 12, and the third element [80Ni 20Fe] is the pinned FM layer FM2. Pursuant to equation (5), the composition of this example yields a %ΔR/R of approximately 0.3%.

### Example 13

Point J on curve S1 represents [80Ni 20Fe]-[Pd]-[80Ni 20Fe], where the first element 80Ni 20Fe is the unpinned FM layer FM1, the second element [Pd] is the conductive spacer 12, and the third element 80Ni 20Fe is the pinned FM layer FM2. Pursuant to equation (5), the composition of this example yields a %ΔR/R of approximately 0.2%.

### Example 14

Point K on curve S1 represents [80Ni 20Fe]-[Al]-[80Ni 20Fe], where the first element [80Ni 20Fe] is the unpinned FM layer FM1, the second element [Al] is the conductive spacer 12, and the third element [80Ni 20 Fe] is the pinned FM layer FM2. The square root of the electronegativity difference |Δχ|^{1/2} between Al and its adjacent NiFe layer FM1 is approximately 0.6/eV, which is greater than the intercept point value of 0.5 eV. In this and other similar examples where |Δχ|^{1/2} is greater than 0.5 eV, i.e., greater than the intercept point, then %ΔR/R is set equal to zero. This example further illustrates that the latter statement is true regardless of whether the crystallographic structures of adjacent layers are matched, i.e., 80Ni 20Fe and Al have FCC structures. The present teachings submit that Al may be useful if its electronegativity is matched with that of an appropriate ferromagnetic material.

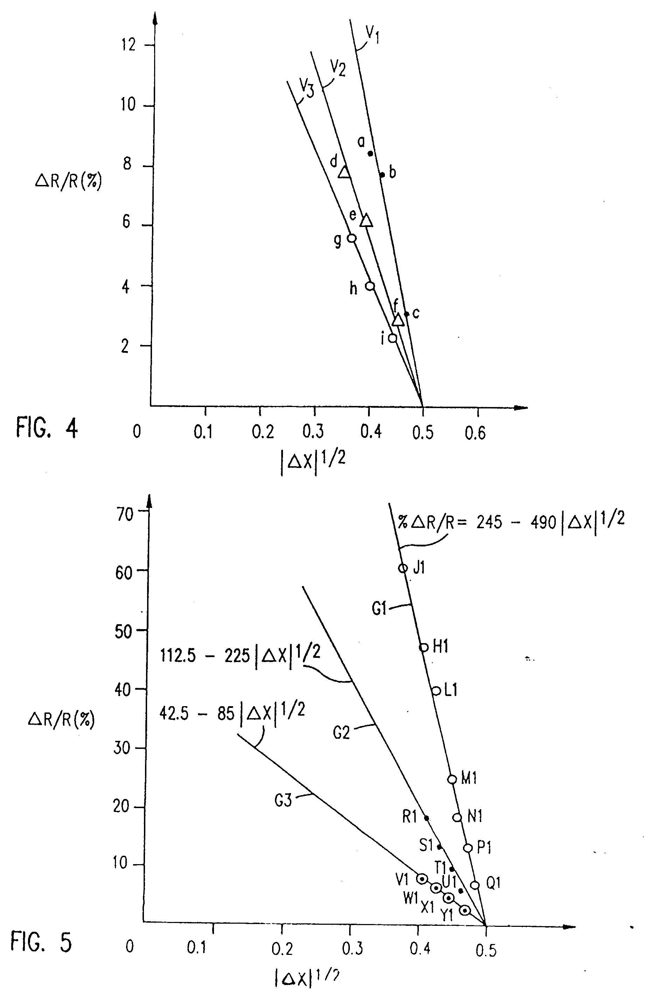

While the relationships described in the equations above, between the sensor output signals (%ΔR/R) and the absolute difference in electronegativities |Δχ|'s of adjacent layers has been described in view of data obtained at room temperature, further analyses confirm that these relationships are also valid for data obtained at other temperatures, including the sensor normal operating temperatures and at cryogenic temperatures as well. It should however be noted that, as shown in Fig. 4, the slope of the curve S1, i.e., the constant value A, will vary at different temperatures.

The following examples 15 through 17 are made with reference to Fig. 4 which graphically illustrates the linear relationships between the %ΔR/R of the spin valve sensor 10 (Fig. 1) relative to the square root of the absolute value of the electronegativity difference (|Δχ|^{½} of the average electronegativity of the pinned and unpinned FM layers FM1 and FM2 and the spacer 12. The response is shown at three different measurement temperatures, that is, 300°K, 200°K and 100°K.

Prior to the development of the relationship of the form of equations (3) and (4), no known quantitative method to maximize %ΔR/R was available in the prior art. By using equation (4) it is now possible to rationalize the selection of the materials forming the FM layers and are the conductive spacers, thus substantially minimizing the need for conventional trial and error selection processes. Consequently, the selection process can now be automated and/or rationalized, and significant cost savings can be achieved in the development of superior spin valve and GMR sensors. More particularly, an appropriate selection of materials can significantly improve the signal output of the spin valve sensor 10, which is a result that is highly sought and of great commercial value.

The following examples are added for the purpose of illustration and explanation only. They are not intended to be exclusive or to limit the coverage of the present inventive concepts, including the selection process and the sensors. The values in these examples represent measurements at room temperature and lower temperatures as well.

### Example 15

This example is represented by the curve V1 of Fig. 4 and graphically plots the linear relationship at a measurement temperature of 100 °K. Points "a", "b" and "c" reflect data for the following respective compositions:
The unpinned FM layer FM1:
   Co (point a), 80Ni 20Fe (point b), and Ni (point c),
The pinned FM layer FM2: {80Ni 20Fe].
The conductive spacer 12: Cu with a approximate thickness of 22A.

The χ values used for the FM layers are the average of pinned and free layers, χ_{free} + χ_{pinned}.

### Example 16

This example is represented by the curve V2 and graphically plots the linear relationship at a temperature of 200 °K. Points "d", "e" and "f" reflect data reported for similar compositions as in Example 15 above.

### Example 17

This example is represented by the curve V3 and graphically plots the linear relationship at a temperature of 300 °K. Points "g", "h" and "i" reflect data reported for similar compositions as in Examples 15 and 16 above.

For spin valve structures, the conductive spacer separating the FMs is generally between 18A° and 30° thick, while the FMs generally range between 30A° and 120A° with an optimum thickness typically at 60A° each. Fig. 5 graphically illustrates linear relationships between %ΔR/R of the GMR sensor 20 (Fig. 2) relative to the square root of the electronegativity difference |Δχ|^{½} of the FM layers FM and the spacers 22. %ΔR/R was measured at room temperature, for various cobalt nickel alloys. The resulting linear relationships are represented by three exemplary curves G1, G2, G3, and hold true for various GMR FM layer compositions. The curves G1, G2, G3 may be expressed generally by the following equations (6), (7) and (8), that continue to confirm equations (3) and (4).

Curve G1 may be expressed by the following equation (6), and relates to the GMR first peak at a Cu thickness of approximately 10A:${\text{%ΔR/R ≅ 245 - 490 |Δχ|}}^{\text{½}} \text{.}$

Curve G2 may be expressed by the following equation (7), and relates to the second GMR peak at a Cu thickness of approximately 22A:${\text{(7) %ΔR/R ≅ 110 - 220 |Δχ|}}^{\text{½}} \text{.}$

Curve G3 may be expressed by the following equation (8), and represents the third GMR peak at a Cu thickness of approximately 32A to 36A:${\text{%ΔR/R ≅ 45 - 90 |Δχ|}}^{\text{½}} \text{.}$

While only three peaks are illustrated, it should be clear that other peaks can also be used, i.e., the 4th or 5th Cu thickness at each of the first through fourth (or subsequent) peaks increases progressively to some optimal value, maximizing %ΔR/R for each particular peak. Increasing peak number or spacer thickness results in the switching field (ie., the field required to express the maximum %ΔR/R) at that particular peak to progressively decrease to lower values, and the sensitivity (ie., %ΔR/R per Oersted) to increase. Depending on the particular application, it is possible to select any of the GMR peaks. Additionally in GMR structures the FMs mcy range in thickness from 4A° to 25A°

By using equations (3) and (6), (7) and (8) it is now possible to simplify the selection of the materials forming the various FM layers and conductive spacers 22 of the GMR sensor 20, similarly to what has been explained above in relation to the spin valve sensor 10.

In addition, the following exemplary embodiments show that by a proper selection of the composition of the materials forming the sensor 20, and by matching or substantially minimizing the absolute electronegativity difference (or mismatch) of its layers (FM and conductive spacer), it is possible to obtain significantly higher output signals (%ΔR/R) than those attained so far using prior methods. The foregoing linear relationships were mostly obtained using data at room temperature. Further analyses confirm that these relationships are also valid for data obtained or derived at other temperatures, including the sensor normal operating temperatures of approximately 45°C and cryogenic temperatures as well. It should be noted that the slopes of the curve G1, G2, G3, i.e., the constant value B, will vary at different temperatures.

An important finding of the present invention may be derived from equations (6), (7) and (8) namely that all the curves G1, G2 and G3 converge at a single intercept point (I), at which %ΔR/R = 0, when |Δχ|^{½} ≅ 0.5, regardless of the measurement temperatures and material compositions of the layers.

The present analysis recognizes the need for optimizing the roughness of the interface for maximizing %ΔR/R for any particular interface. Accordingly, the curves G1, G2, G3 take into consideration the fact that different experimenters may conduct their experiments under different conditions, such as different substrate temperatures, different deposition rates, different Argon background sputtering pressure, and thus will realize different degrees of interfacial roughness. Again we reiterate that the interfacial surface roughness will vary the slopes of curves G1, G2 and G3 and that some optimum roughness exists that maximizes %ΔR/R for any interface Δχ of the FM and spacer layers.

### Example 18

Fig. 5 shows the value of %ΔR/R for a GMR structure at three peaks as a function of NiCo alloy compositions.
Point H1 represents the composition: Ni30-Co70
Point J1 represents the composition: Co
Point L1 represents the composition: Ni50-Co50
Point M1 represents the composition: Ni70-Co30
Point N1 represents the composition: Ni80-Co20
Point P1 represents the composition: Ni90-Co10
Point Q1 represents the composition: Ni
All compositions of previous examples and this example 18 are given in Atomic %

### Example 19

On the second GMR peak curve G2, points R1 and S1 correspond to the respective compositions of points J1, H1, and M1 along the first peak curve G1. R1 is Ni50-Co50; S1 is Ni70-Co30; T1 is Ni80-Co20; and U1 is Ni.

### Example 20

On the third GMR peak curve G3, V1 is Ni30-Co70; W1 is Ni50-Co50; X1 is Ni70-Co30; and Y1 is Ni.

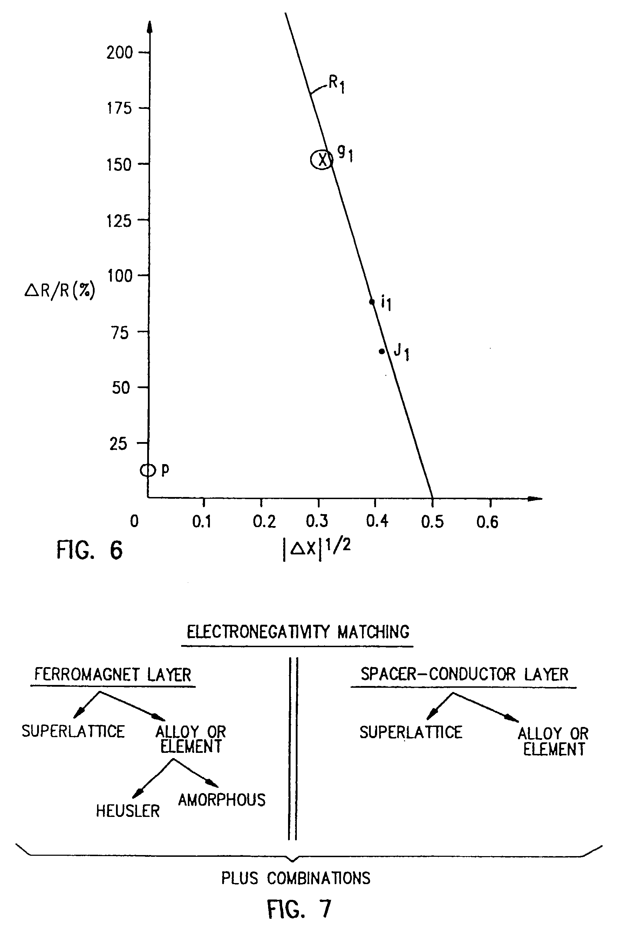

Fig. 6 graphically illustrates three linear relationships between %ΔR/R of the GMR sensor 20 (Fig. 2) relative to the square root of the electronegativity difference |Δχ|^{½} of the FM layers FM and the spacers 22 at a temperature of 5 °K. These linear relationships are represented by three exemplary curves R1, R2, R3.

Curve R1 may be expressed by the following equation (9), and relates to the GMR first peak:${\text{%ΔR/R ≅ 330 - 660 |Δχ|}}^{\text{½}} \text{|Δ}$

Curve R2 may be expressed by the following equation (10), and relates to the second GMR peak:${\text{(10) %ΔR/R ≅ 158 - 316 (|Δχ|)}}^{\text{½}} \text{.}$

Curve R3 may be expressed by the following equation (11), and relates to the third GMR peak:${\text{%ΔR/R ≅ 118 - 236 (|Δχ|)}}^{\text{½}} \text{.}$

### Example 21

On the first GMR peak curve R1, the exemplary compositions are expressed as follows X-Y, where element X represents the material for the FM layers FM, and element "Y" represents the material for the conductive spacers 22.
Point g1 represents the following composition: Fe/Cr.
Point i1 represents the following composition: Co/Cu.
Point j1 represents the following composition: Co/Ag.

### Example 22

On the second GMR peak curve R2, points k1 and l1 correspond to the respective compositions of points i1 (Co/Cu), and j1 (Co/Ag) along the first peak curve G1.

### Example 23

On the third GMR peak curve R3, points m1 and n1 correspond to the respective compositions of points i1 (Co/Cu), and j1 (Co/Ag) along the first peak curve G1.

The foregoing example 1 through 21 confirms that the FCC and BCC systems obey the same or substantially similar principle as expressed by equations 3 and 4. Additionally it is shown that an FCC FM layer should be matched with an FCC conductive spacer, and a BCC FM layer should be matched with an BCC conductive spacer. For instance, when this lattice type matching, i.e., FCC on FCC and BCC on BCC ferromagnets and spacers, equations 3 and 4 are obeyed, relative to point "g" in example 1 above, both Fe and Cr are BCC elements, while the remaining exemplary points "h" through "j" relate to FCC conductors and ferromagnets.

Point "p" relates to the GMR structure Fe - Cu. This structure presents an almost perfect electronegativity match i. e., (Δχ ≈ 0) between the Fe and Cu layers, nonetheless, this structure does not provide a high %ΔR/R since Fe is a BCC element, while Cu is a FCC element. Accordingly extremely inferior %ΔR/R is obtained and equations (3 and 4) are not obeyed due to potential barriers created by the lattice type mismatch, that is, BCC/FCC.

The foregoing examples also confirm that the BCC and FCC systems are also similarly governed by the interfacial electronegativity matching principle, i.e., they have the same functionality of |Δχ|^{1/2} verses %ΔR/R as expressed by equations (3) and (4) and shown by example 21.

Fig. 7 is a chart that graphically illustrates various exemplary combinations and compositions for the FM layers and spacers, some of which are explained by the following examples. In general, the FM alloys are selected from a group comprised of Fe, Co, Ni, and their alloys and substitutional alloys thereof. In addition, the conductive alloys are selected from a group comprised of Au, Cu, Ag and substitutional alloys thereof, and other suitable intermetalic compounds possessing resistivities

### Example 24

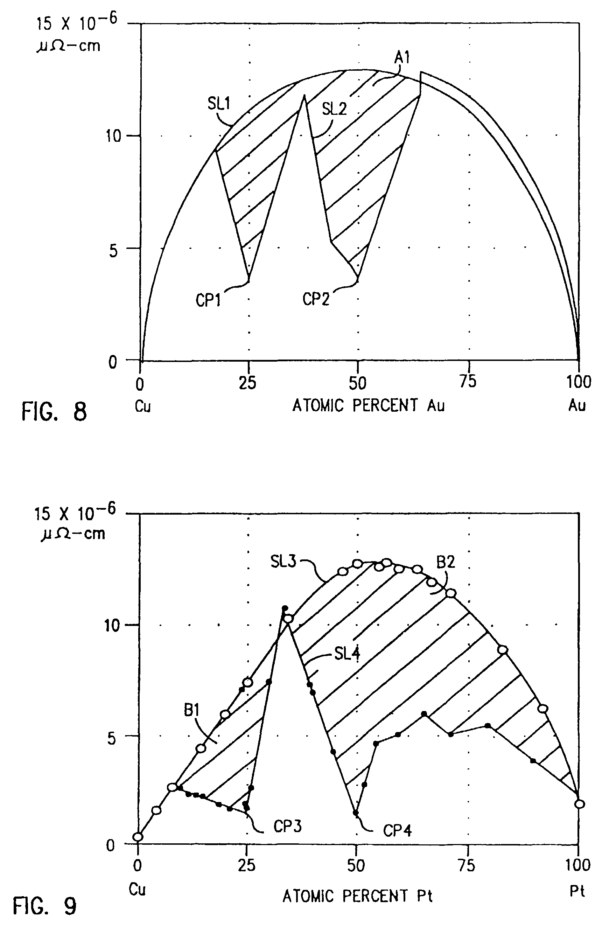

Fig. 8 shows two graphs SL1, SL2, plotting the electrical resistivity in micro Ohmcm versus the atomic composition for the Cu-Au superlattice system. Graph SL1 illustrates the relationship for alloys that are quenched (disordered state). Graph SL2 illustrates the relationship for alloys that are annealed at 200°C for the purpose of rendering an ordered superlattice structure. Fig. 8 further shows that the specific electrical resistivities (microohm-cm) of the ordered superlattice relative to the same composition of the disordered alloy may be reduced significantly by annealing the alloys at predetermined atomic compositions. In the Cu-Au system exemplified in Fig. 8, two such predetermined atomic compositions are shown, the first (CP1) at 25 atomic percent of Au, and the second (CP2) at 50 atomic percent of Au. For the purpose of explanation, these atomic compositions at which the specific electrical resistivities of the alloys drop to a minimal level and the superlattice is formed, will be referred to herein as "critical points" (CP). Additional discription of superlattice structures may be found in C. Barrett, Ph.D.,"Structure of Metals, Crystallographic Methods, Principles, and Data", McGraw-Hill Book Company, Inc. (1952), second edition, 269-296, which is incorporated herein by reference.

### Example 25

Fig. 9 shows two graphs SL3, SL4, plotting the electrical resistivity in micro ohmcm versus the atomic composition for the Cu-Pt superlattice system. Graph SL3 illustrates the relationship for alloys that are quenched and cold worked (disordered state). Graph SL4 illustrates the relationship for alloys that are annealed at 300°C for rendering an ordered superlattice structure. Fig. 9 further shows that the specific electrical resistivities of the ordered superlattice may be reduced significantly by annealing the alloys at two critical points CP3 (25% atomic percent Pt), and CP4 (50% atomic percent Pt).

While points CP1 and CP2 (Fig. 8) and CP3, CP4 (Fig. 9) reflect the most useful compositions, other compositions defined by the hatched areas A1 (Fig. 8) and B1, B2 (Fig. 9) between the envelopes of the disordered alloys (SL1, SL3) and the envelopes of the ordered alloys (SL2, SL4) may also be useful in providing a broader electronegativity selection range, while at the same time producing a partially ordered superlattice that will have some benefit in extending the thermal stability of spin valve and GMR sensors using the ordered alloys.

For example, the two alloy series in examples 24 and 25 may be annealed at between 120 °C to 250 °C in thin film form for approximately 0.5 hour to 4 hours to form the superlattice at appropriate composition. The present invention proposes the use of superlattices processed at or near critical points CP or within any of the shaded regions in the CuAu binary systemor the CuPtbinary system. The shaded regions define the composition range within which some degree of superlattice order will occur and which may be used advantageously. Clearly the most advantageous compositions from a resistivity point of view are a 25 and 50 atomic % for both the CuAu and CuPt. These superlattice alloys and compositions can be utilized to match the electronegativeity of 80Ni-20Fe, for example, more advantageously. The benefits are shown in the following examples. Similar superlattice alloys in the AgPd ssystem may be used to advantage as well. These are Cu₃Pd or CuPd.

### Example 26

A superlattice spacer 22 will provide a large mean free path in the spacer while simultaneously minimizing the electronegativity difference |Δχ| between the FM layers and the superlattice spacers 22. For example, 50:50 CuAu superlattice alloy (Fig. 9) exhibits a resistivity of about 3.5 µΩ-cm, which is similar to the resistivity of gold, and an average electronegativity (χ) of approximately 2.07 eV.

In this example Permalloy (Ni80 - Fe20) is used as a FM layer. The electronegativity of 80:20 NiFe is about 2.095 eV and the electronegativity of the 50:50 CuAu superlattice alloy is approximately 2.07 eV, resulting in an absolute electronegativity difference |Δχ| of about 0.025 eV. This excellent match will significantly minimize the detrimental interfacial scattering component in the spin valve sensor 10 and the GMR sensor 20, with a result of maximizing sensor signal output %ΔR/R.

### Example 27

In this example, the 50:50 CuAu superlattice alloy of Example 24 is used as a spacer, while cobalt (Co) is used as a FM layer. Since the electronegativity of Co is about 2.05 eV and the electronegativity of the 50:50 CuAu superlattice alloy is approximately 2.07 eV, thus resulting in an absolute electronegativity difference Δχ of 0.02, which provides a superior electronegativity match.

### Example 28

In this example, a 50:50 CuAu superlattice (Figure 5) is used as a spacer, while an Ni₃Fe superlattice composition forms the FM layers. The average electronegativity of the 50:50 CuAu superlattice is about 2.07, which has an absolute electronegativeity difference of about 0.01 with N₁₃Fe.

In addition to increasing the sensor output signals (%ΔR/R), the dual superlattice structure increases the thermal stability as well as the chemical stability of the sensors 10, 20. For instance, since the superlattice alloys are greatly more corrosion resistant than copper and the ferromagnet alloys, the sensors 10, 20 using the superlattices formed at or near critical points result in a structure of superior electromigration characteristics as well.

As mentioned earlier, one method for processing the superlattice is to anneal the alloys between 120°C to 250°C for 10 to 200 minutes. An alternative method is to deposit the superlattice alloys by sputtering or evaporation, at a relatively low rate, on a sufficiently heated substrate. This slow deposition process could form the superlattice structure without the need for annealing.

Another advantage for using superlattice structures is that such structures have high critical temperatures above which they become disordered. These critical temperatures exceed 350°C in bulk, that is well above the normal operating temperatures of the sensors 10, 20.

The alloys that are used to achieve the preceding objectives are from the group constituting Fe, Ni, Co or any combination of these elements, and alloys thereof which, may be alloyeed with elements or combination thereof from the group consisting of Au, Cu, Mn, Ti, V, Pt, Pd, Ru, Ir, Sn, Ta, Nb, Rh, N, C, Zr, Hf, Y, La, and rare earth elements, either in crystalline FCC or BCC form or in amorphous form containing a combination of the above elements.

### Example 28

Specifically, a group of quaternary FM alloys with minimal magnetostriction includes:$\begin{matrix}\begin{matrix}\text{[48Co - 29Ni - 23Fe] 1-yPd.} \\ \text{[26Co - 44Ni - 30Fe] 1-yPd.}\end{matrix}\end{matrix}$ In the foregoing two alloys, y represents the atomic fraction, and for (12 to 30)Pd, these alloys display near zero magnetostriction and low overcivity. More specifically, the following alloys have near zero magnetostriction and have χ values of 2.13. Each alloy can be matched with the superlattice composite conductive spacer of CuPt
whose χ is approximately 2.12.$\begin{matrix}\begin{matrix}\text{33.6Co - 20.3Ni - 16.1Fe - 30Pd.} \\ \text{18.2Co - 30.8Ni - 21Fe - 30Pd.}\end{matrix}\end{matrix}$

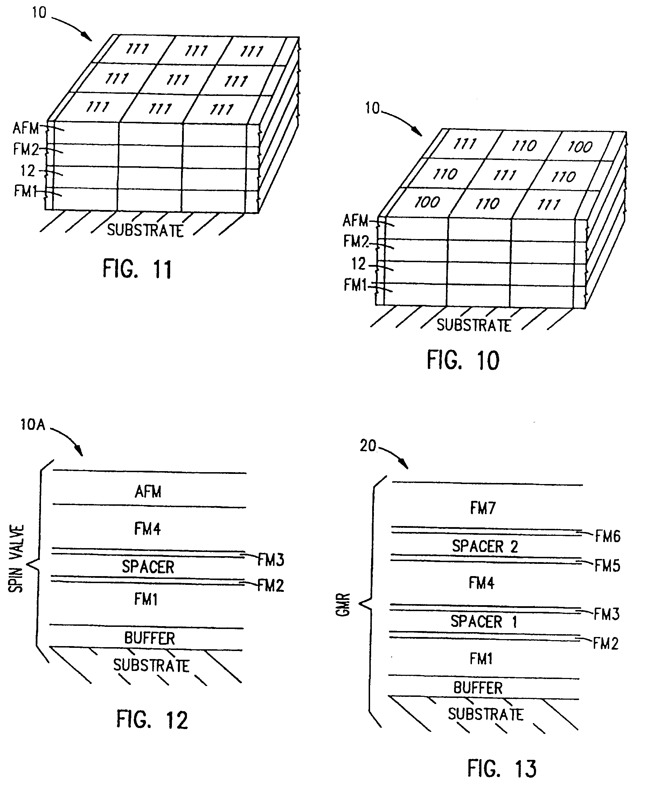

The electronegativity matching between adjacent layers, as described in the foregoing equations may be carried out on a face-to-face or surface-to-surface basis. Fig. 10 illustrates the use of single crystals in the spin valve sensor 10 of Fig. 1. In this particular example the surface crystalline orientation of the substrate has been selected to be 111. As a result, the subsequent single crystal layers that are formed on top of the substrate will automatically assume the same 111 surface orientation. It is an object of the present invention to match the electronegativities of the selected crystalline orientation or face, which in this example is 111, of the juxtaposed layers, rather than to match the average electronegativities of these layers.

According to a preferred embodiment, the spin valve sensor 10 is formed by selecting the desired spacer material and one of its three main crystalline orientations, for instance 111. Subsequently, the FM layers FM are selected such that the electronegativity of their corresponding faces with a 111 crystalline orientation matches or substantially approximates the electronegativity of the selected spacer crystalline face, i.e., 111. Similarly, the 110 and 100 surface faces can be matched as well by selecting the proper alloys. All examples up to this point were directed to polycrystalline ferromagnets and conductive spacers wherein the orientation of the individual crystallographic faces, i.e., 111, 100 and 110 are all present at about the same frequency of occurence. Given that the faces are equally presented to a grainy surface during the fabrication of spin valve or GMR sensors, the relevant electronegativeity of this random orientating crystallographic face is expressed by equation (12) wherein χₛ' of each principal face, i.e., 111, 100 and 110 contribute equally to the polycrystalline χ.${\text{χ(polycrystalline) = 1/3 (χ}}_{\text{111}} {\text{+ χ}}_{\text{100}} {\text{+ χ}}_{\text{110}} \text{)}$ where n is an integer that is equal to 3 and representing the three main faces, and χi refers to the electronegativity of each of the three main faces.

Fig. 11 illustrates the use of polycrystals in the spin valve sensor 10 of Fig. 1. In this particular example, the crystalline orientation of the substrate is random, and therefore the three main crystallographic orientations, i.e., 100, 110, 111 have approximately the same frequency of surface occupancy on the substrate. As a result, the subsequent polycrystal layers FM and AFM that are formed on top of the substrate will automatically assume the same random orientation as the substrate by epitaxy of the underlying polycrystals of the prior spacer or FM layer FM. It is an object of the present invention to match the average electronegativity of each layer to the average electronegativity of the adjacent layers.

According to a preferred embodiment, the spin valve sensor 10 is formed by selecting the desired spacer material. Subsequently, the FM layers FM1 and FM2 are selected such that their average electronegativities match or substantially approximate the average electronegativity of the selected spacer 12.

The following example 29 illustrates the impact of the mismatch of the electronegativity (|Δχ|) on the various faces 100, 110, 111 of polycrystalline nickel and polycrystalline copper.

### Example 29

The electronegativity values and the electronegativity difference for the three faces of copper and nickel are listed in the following table:

| Cu (face) | χCu (face) | Ni (face) | χ Ni (face) | \|Δχ\|^{1/2} (face) for a spin valve |
|---|---|---|---|---|
| Cu(111) | 2.041 | Ni (111) | 2.204 | 0.40 |
| Cu(100) | 1.87 | Ni(100) | 2.146 | 0.525 |
| Cu(110) | 1.821 | Ni(110) | 2.068 | 0.498 |

Applying equation (5) above, we can illustrate the impact on %ΔR/R as a function of the face, assuming equal surface occupancy of each principal face:${\text{%ΔR/R = 1/3 { [35.20-70.40(0.404)]}}_{\text{111}} {\text{+ [35.20-70.40(0.525)]}}_{\text{100}} {\text{+ [35.20-70.40(0.498)]}}_{\text{110}} \text{} %.}$

In this equation, if |Δχ|^{1/2} ≥ 0.5 then |Δχ|^{1/2} is set equal to zero, and thus:$\text{%ΔR/R = 1/3 (6.758 + 0 + 0.14)% ≅ 2.30%,}$ which value is close enough to the experimentally observed value of 2.5%, thus indicating that there is some probable preferred orientation and the sample was not completely random. The point to be illustrated is that essentially one face, in this example the face with the 111 surface orientation, contributes over approximately 90% of the %ΔR/R of the observed value, and thus emphasizes the necessity for matching the electronegativity on a single crystallographic face of the FM layer and the spacer for optimal %ΔR/R. By implementing this observation it is possible to triple %ΔR/R. The same observation applies to GMR structures as well.

Figs. 12 and 13 illustrate a spin valve sensor 10A and a GMR sensor 20A respectively. The spin valve sensor 10A includes two or more compound FM interfaces (FM1, FM2) and (FM3, FM4) which are composed of different ferromagnetic materials. Similarly, the GMR sensor 20A includes a plurality of electrically conductive spacers, such as SPACER 1, that is interposed between, and interface with compound FM layers, such as (FM1, FM2), (FM3, FM4, FM5), (FM6, FM7). These compound interfaces follow similar rules to those of the coumpounds interfaces (FM1, FM2) and (FM3, FM4) of Fig. 12. In a preferred embodiment, all the interfaces between the FM layers (FM1, FM2, FM3, FM4 and spacer follow the electronegativity matching and other selection criteria described herein. In addition, the counpound interfaces enable the adjustment of the overall magnetostriction for the spin valve sensor 10A and the GMR sensor 20A. For the structures of Fig. 12 (spin valve) and Fig. 13, GMR FM1 and FM4 may be identical compositions, or may be different compositions, and the same applies to FM2 and FM3. While in the preferred embodiment, FM2 and FM3 are of the same composition, FM1 and FM4 are of the same composition as well. The basis for having two or more different compositions is that the magnetostriction thickness product of FM1 and F2 may be arranged so that +λₛt_{FM1} _ -λₛt_{FM2}, where t is thickness, resulting in an average λₛ (magnetostriction) for both layers approaching zero for the composite FM elements.

It is not necessary to match thicknesses of FM1 and FM2, or FM3 and FM4, to minizize magnetostriction. Even an unbalanced thickness of each will lower λₛ for improved results that minimizes magnetostriction of a compound FM structure. What is critical is that the ferromagnets immediately adjacent to the spacers minimize their Δχ relative to the chosen spacer. Entirely similar conditions prevail for the GMR structure of Fig. 13 as well. Thus, the compound FM structure in spin valve structures and GMR structures, in combination with the preceding teaching requiring the minimization of Δχ between FM and spacer, allows for maximizing %ΔR/R while simultaneously maximizing corrosion resistance and minimizing the magnetostriction of compound ferromagnet structures of spin valve structures or GMR structures.

In the above example, it was demonstrated in the Ni-Cu multilayer system that ≈90 + % of %ΔR/R was due to crystallites comprising the multilayer spin valve that were in the 111 surface orientation. It is well known that even in polycrystalline films with random surface orientations of 111, 100 and 110 planes that epitaxy of the succeeding Cu and FM films will occur, i.e., the orientation effect is carried throughout the structure.

### EXAMPLE 30

The selection of crystal orientation, 111, 100 or 110 can be accomplished by selecting a single crystal substrate such as single crystal magnesium oxide with surface orientations of either 111, 100 or 110. By selecting a single orientation, for example 111 of
the substrate and subsequently selecting a ferromagnet and conductive spacer whose Δχ's are minimized, and subsequently depositing alternating layers of FM and conductive spacers on such an oriented substrate, results in %ΔR/R's that will be greater than randomly oriented polycrystalline structures.

Prior to the deposition of alternating ferromagnets and spacers, it would be desirable to deposit a first layer of Pt, Pd, Au or Cr of 10 Å to 50 Å with subsequent annealing at approximately 250-400°C to establish an epitaxial oriented metal film from which subsequent epitaxy of the selected alternating FM/spacer materials are then subsequently deposited with epitoxialintegrity maintained at each subsequent layer in the formation of a spin valve or GMR structure.
Since interfacial diffusion kinetics between the FM and the conductor spacer are expected to be a function of selected orientation, that is, 111, 100 or 110, the surface roughness of each selected orientation is optimized by optimizing the deposition conditions for each orientation. In this way, a maximum %ΔR/R can be achieved for each principal orientation, 111, 100 or 110.

Since no χ or Ø values are found in the literature for alloys, we estimate the 111, 100, 110 χvalues of the polycrystalline value of the alloy for whichthe method of calculation has been shown. By using FCC elements such as Ni, Al, Ag, Ir, CU, and their polycrystalline χ values and noting the ratio of the above elements to the polycrystalline value, we can arrive at an estimate of the 111, 100, 110 χ values for any arbitrary FCC alloy. The result is as follows, where χpc = χ_{polycrystalline}:$\begin{matrix}\begin{matrix}{\text{χ}}_{\text{111}} {\text{_ 1.027 χ}}_{\text{PC}} \\ {\text{χ}}_{\text{100}} {\text{_ 1.007 χ}}_{\text{PC}} \\ {\text{χ}}_{\text{110}} {\text{_ 0.965 χ}}_{\text{PC}}\end{matrix}\end{matrix}$

Accordingly, these estimates provide a basis for matching single crystal orientations of the FM alloy with single crystal orienatations of the conductive spacers for the purpose of minimizing Δχ.

### EXAMPLE 31

Heusler alloys represent another class of ferromagnetic materials possessing a superlattice structure that may be partially or fully ordered. Full ordering is possible at or very near to the general stoichiometric composition M₂MₙM¹ and may contain ferromagnetic elements Co and Ni for M₂ as well as the nonferromagnetic elements Cu, Pd, Pt and Au; whereas M¹ may be Al, Ga, As, In, Sb, Sn or Bi. The Heusler alloys containing full complements of Pt, Au, Pd have Curie temperatures below room temperatures, i.e., below 300°K and accordingly may, if their resistivity ≤ 20 microohm cm., be used as spacers for other ferromagnetic Heusler alloys. It is also possible to admix for M₂, Cu, Co, Ni, Pd, Pt, Au and Ir for the purpose of fine control of the electronegativity of the Heusler alloy to minimize Δχ of the Heusler alloy and its spacer element or alloy or compound.

A representative series of Heusler alloys and their electronegativities is illustrated below:

| Heusler Alloy | χalloy |
|---|---|
| Cu₂MnAl | 1.80 |
| Ni₂MnSn | 1.93 |
| Co₂MnGe | 1.94 |
| Co₂MnSi | 1.93 |
| Co₂MnSn | 1.89 |
| CuPdMnSn | 1.92 |
| NiAuMnSn | 1.95 |

The above ferromagnetic superlattice alloys may be used in conjunction with Cu, CuAu alloys, with Au at 5-15 atomic % and intermetallic spacers Al₂Au with χ = 1.88 and PtAl₂ whose χ = 1.92. AgAu alloys may be used as well with Au less than 25 atomic %.

A list of χ values that are relevant to most ferromagnetic alloys and conductive spacer compounds or alloys is provided below:

| Element | Polycrystalline χ | Bulk Crystal Structure |
|---|---|---|
| Au | 2.22 | FCC |
| Fe | 1.91 | BCC |
| Cu | 1.91 | FCC |
| Ag | 1.89 | FCC |
| Pt | 2.34 | FCC |
| Pd | 2.32 | FCC |
| Ir | 2.32 | FCC |
| Rh | 2.04 | FCC |
| Co | 2.05 | FCC in thin films |
| Ni | 2.14 | FCC |
| Mn | 1.65 | Complex |
| Cr | 1.83 | BCC |
| Ti | 1.76 | |
| V | 1.74 | BCC |
| Ru | 1.92 | CPH close packed hexagonal |
| Sn | 1.79 | Complex |
| Ta | 1.73 | BCC |
| Nb | 1.75 | BCC |
| Zr | 1.63 | BCC CPH |
| Hf | 1.57 | CPH |
| Y | 1.21 | CPH |
| La | 1.39 | FCC CPH |
| Rare earth elements | ^{∼}1.21 | Complex CPH FCC BCC |
| C | ^{∼}2.52 | Various forms |
| N | ^{∼}3.01 | Gaseous |
| Al | ^{∼}1.72 | FCC |
| Ge | ^{∼}2.00 | |
| Si | ^{∼}1.96 | |
| Bi | 1.71 | |
| As | 1.50 | |

By virtue of this invention, a method and means has been provided for selecting the materials of spin valve and GMR sensors to yield minimal difference in electronegativity between the sensor layers.

## Claims

1. A method of making sensors (10) formed with ferromagnetic layers (FM1, FM2), and conductive spacers (12) interposed between the ferromagnetic layers (FM1, FM2), for use in data storage devices, comprising the steps of:
selecting a first material of either said ferromagnetic layers (FM1, FM2) or said electrically conductive spacers (12) having a first electronegativity; and
selecting a second material for said other nonselected one of said ferromagnetic layers (FM1, FM2) and said conductive spacers (12) having a second electronegativity;
wherein the absolute difference between said first and second electronegativities is minimized.

2. The method as in claim 1, wherein said ferromagnetic layers (FM1, FM2) comprise a plurality of layers having a plurality of different electronegativities.

3. The method as in claim 1 or 2, wherein said step of selecting said electrically conductive spacer material includes the step of selecting material from the group comprising Cu, Ag, Au, Pt, Pd, Cu₃Pt, CuPt, Cu₃Au, CuAu and Cr.

4. The method as in any one of the preceding claims, wherein said step of selecting said ferromagnetic layers (FM1, FM2) includes the step of selecting materials from the group comprising NiFe(80:20), Ni₃Fe, Ni₃Mn, Fe₄Mn, FePd, Fe_{1-y} Au_{y}, Co_{1-z} Au_{z}, where y is the atomic fraction with a value between 0.30 and 0.70, and z is the atomic fraction with a value between 0.10 and 0.50.

5. The method as in any one of the preceding claims, wherein said step of selecting said electrically conductive spacer (12) includes the step of selecting Cr. and wherein said step of selecting said ferromagnetic layers (FM1, FM2) includes the step of selecting ferromagnetic materials from the group comprising Fe₁₋ᵥ Crᵥ, Fe_{1-w} V_{w}, ternary FeCrV systems, where u is the atomic fraction with a value between 0.40 and 0.70, and w is the atomic fraction with a value between 0.25 and 0.35.

6. The method as in any one of the preceding claims, wherein said step of selecting said electrically conductive spacer (12) includes the step of defining said at least first and second electronegativities according to the following equations:$\begin{matrix}\begin{matrix}\text{χ (spacer) = 0.44 φ(spacer) - 0.15, and} \\ \text{χ (FM) = 0.44 φ (FM) - 0.15,}\end{matrix}\end{matrix}$ where φ(spacer) and φ(FM) are the work functions of said electrically conductive spacer (12), and said ferromagnetic layers (FM1, FM2).

7. The method as in claim 6, wherein the step of selecting said electrically conductive spacer (12) includes the step of selecting a binary conductive alloy(a-b) having an electronegativity χ and formed of a plurality of elements a and b, where said elements a and b have electronegativities χₐ and χ_{b}, and atomic fractions fₐ and f_{b}, respectively; and
wherein said electronegativity of said alloy χ is defined by the following equation:${\text{χ}}_{\text{(alloy a-b)}} {\text{= χ}}_{\text{a}} {\text{.f}}_{\text{a}} {\text{+ χ}}_{\text{b}} {\text{. f}}_{\text{b}} \text{.}$

8. The method as in claim 6, wherein the step of selecting said electrically conductive spacer (12) includes the step of selecting a ternary conductive alloy(a-b-c) having an electronegativity χ and formed of a plurality of elements a, b and c;
wherein said elements a, b and c have electronegativities χ_{a,} χ_{b} and χ_{b}, and atomic fractions fₐ, f_{b} and f_{c} respectively; and
wherein said electronegativity of said alloy χ is defined by the following equation:${\text{χ}}_{\text{(alloy a-b-c)}} {\text{= χ}}_{\text{a}} {\text{.f}}_{\text{a}} {\text{+ χ}}_{\text{b}} {\text{. f}}_{\text{b}} {\text{+ χ}}_{\text{c}} {\text{. f}}_{\text{c}} \text{.}$

9. The method as in claim 6, wherein the step of selecting said ferromagnetic layers (FM1, FM2) includes the step of selecting a binary ferromagnetic alloy(x-y) having an electronegativity χ and formed of a plurality of elements x and y;
wherein said elements x and y have electronegativities χₓ and χ_{y}, and atomic fractions fₓ and f_{y} respectively; and
wherein said electronegativity of said alloy χ_{(alloy x-y)} is defined by the following equation:${\text{χ}}_{\text{(alloy x-y)}} {\text{= χ}}_{\text{x.}} {\text{f}}_{\text{x}} {\text{+ χ}}_{\text{y}} {\text{. f}}_{\text{y}} \text{.}$

10. The method as in claim 6, wherein the step of selecting said ferromagnetic layers (FM1, FM2) includes the step of selecting a ternary ferromagnetic alloy(x-y-z) having an electronegativity χ and formed of a plurality of elements x, y and z;
wherein said elements x, y and z have electronegativities χₓ, χ_{y} and χₓ and atomic fractions fₓ, f_{y} and f_{z} respectively; and
wherein said electronegativity of said alloy χ_{(alloy x-y-z)} is defined by the following equation:${\text{χ}}_{\text{(alloy x-y-z)}} {\text{= χ}}_{\text{x}} {\text{.f}}_{\text{x}} {\text{+ χ}}_{\text{y}} {\text{. f}}_{\text{y}} {\text{+ χ}}_{\text{z}} {\text{. f}}_{\text{z}} \text{.}$

11. A method of optimizing the interfacial properties of a data storage device comprising the steps of:
selecting at least one electrically conductive spacer (12) having a first work function (φ spacer); and
selecting ferromagnetic layers (FM1, FM2) having at least a second work function (φ FM);
wherein said selecting steps include the step of matching said at least first and second work functions.

12. A data storage device comprising:
a substrate;
at least one electrically conductive spacer (12) having a first electronegativity; and
ferromagnetic layers (FM1, FM2) having a second electronegativity disposed adjacent to said conductive spacer (12);
wherein said conductive spacer (12) and said ferromagnetic layers (FM1, FM2) are selected such that said first and second electronegativities are matched for optimizing the interfacial properties of the data storage device.

13. The data storage device as in claim 12, wherein said first electronegativity corresponds to a first work function;
wherein said second electronegativity corresponds to a second work function; and
wherein said at least first and second work functions are matched for optimizing the interfacial properties of the data storage device.

14. The data storage device of claim 12 or 13, wherein the difference between said first and second electronegativities is minimized according to the following equation:$\text{|Δχ| = χ (FM) - χ (spacer) ≈ 0.}$

15. The data storage device as in any one of claims 12 to 14, wherein said first and second electronegativities are defined according to the following equations:$\begin{matrix}\begin{matrix}\text{χ (spacer) = 0.44 φ(spacer) - 0.15, and} \\ \text{χ (FM) = 0.44 φ (FM) - 0.15,}\end{matrix}\end{matrix}$ where φ(spacer) and φ(FM) are the work functions of said electrically conductive spacer (12), and said ferromagnetic layers (FM1, FM2).

16. The data storage device as in any one of claims 12 to 15, wherein said electrically conductive spacer (12) includes a binary conductive alloy(a-b) having an electronegativity χ and formed of a plurality of elements a and b;
wherein said elements a and b have electronegativities χₐ and χ_{b}, and atomic fractions fₐ and f_{b}, respectively; and
wherein said electronegativity of said alloy χ_{(alloy a-b)}is defined by the following equation:${\text{χ}}_{\text{(alloy a-b)}} {\text{= χ}}_{\text{a}} {\text{.f}}_{\text{a}} {\text{+ χ}}_{\text{b}} {\text{. f}}_{\text{b}} \text{.}$

17. The data storage device as in any one of claims 12 to 15, wherein said electrically conductive spacer (12) includes a ternary conductive alloy(a-b-c) having an electronegativity χ and formed of a plurality of elements a, b and c;
wherein said elements a, b and c have electronegativities χₐ, χ_{b} and χ_{b}, and atomic fractions fₐ, f_{b} and f_{c} respectively; and
wherein said electronegativity of said alloy χ_{(alloy a-b-c)} is defined by the following equation:${\text{χ}}_{\text{(alloy a-b-c)}} {\text{= χ}}_{\text{a}} {\text{.f}}_{\text{a}} {\text{+ χ}}_{\text{b}} {\text{. f}}_{\text{b}} {\text{+ χ}}_{\text{c}} {\text{. f}}_{\text{c}} \text{.}$

18. The data storage device as in any one of claims 12 to 15, wherein said ferromagnetic layers (FM1, FM2) include a binary ferromagnetic alloy(x-y) having an electronegativity χ and formed of a plurality of elements x and y;
wherein said elements x and y have electronegativities χₓ and χ_{y}, and atomic fractions fₓ and f_{y} respectively; and
wherein said electronegativity of said alloy χ_{(alloy x-y)} is defined by the following equation:${\text{χ}}_{\text{(alloy x-y)}} {\text{= χ}}_{\text{x}} {\text{.f}}_{\text{x}} {\text{+ χ}}_{\text{y}} {\text{. f}}_{\text{y}} \text{.}$

19. The data storage device as in any one of claims 12 to 15, wherein said ferromagnetic layers (FM1, FM2) include a ternary ferromagnetic alloy(x-y-z) having an electronegativity χ and formed of a plurality of elements x, y and z;
wherein said elements x, y and z have electronegativities χₓ, χ_{y} and χₓ and atomic fractions fₓ, f_{y} and f_{z} respectively; and
wherein said electronegativity of said alloy χ_{(alloy x-y-z)} is defined by the following equation:${\text{χ}}_{\text{(alloy x-y-z)}} {\text{= χ}}_{\text{x}} {\text{.f}}_{\text{x}} {\text{+ χ}}_{\text{y}} {\text{. f}}_{\text{y}} {\text{+ χ}}_{\text{z}} {\text{. f}}_{\text{z}} \text{.}$

20. The data storage device as in any one of claims 12 to 15, wherein said conductive spacer (12) comprises a plurality of electrically conductive spacers (12) having a plurality of electronegativities;
wherein said ferromagnetic layers (FM1, FM2) comprise a plurality of ferromagnetic layers (FM1, FM2) having a plurality of electronegativities; and
wherein said electronegativities of said conductive spacers (12) are matched with said electronegativities of said ferromagnetic layers (FM1, FM2).

21. The data storage device as in any one of claims 12 to 20, wherein said electrically conductive spacer (12) is selected from the group comprising Cu, Ag, Au, Pt, Pd, Cu₃Pt, CuPt, Cu₃Au, CuAu and Cr.

22. The data storage device as in any one of claims 12 to 21, wherein said ferromagnetic layers (FM1, FM2) are selected from the group comprising NiFe(80:20), Ni₃Fe, Ni₃Mn, Fe₄Mn, FePd, Fe_{1-y} Au_{y,} Co_{1-z} Au_{z}, where y is the atomic fraction with a value between 0.30 and 0.70, and z is the atomic fraction with a value between 0.10 and 0.50; or the group comprising Fe₁₋ᵥ Crᵥ, Fe_{1-w} V_{w}, ternary FeCrV systems, where u is the atomic fraction with a value between 0.40 and 0.70, and w is the atomic fraction with a value between 0.25 and 0.35.

23. The data storage device as in any one of claims 12 to 22, wherein at least one of said ferromagnetic layers (FM1, FM2) defines a compound interface with said conductive spacer (12).

24. A method of optimizing the interfacial properties of a data storage device comprising the steps of:
selecting a substrate having a defined crystallographic structure;
selecting at least one electrically conductive, single crystal spacer having a crystallographic structure similar to said substrate crystallographic structure and having a first electronegativity; and
selecting ferromagnetic, single crystal layers having a crystallographic structure similar to said substrate crystallographic structure and having second electronegativity: wherein said selecting steps provide a matching of said at least first and second electronegativities.

25. The method as in claim 24, wherein said step of selecting said substrate includes selecting a substrate material with a face centered cubic structure;
wherein said step of selecting said single crystal spacer includes selecting a spacer material with a face centered cubic structure; and
wherein said step of selecting said single crystal ferromagnetic layers (FM1, FM2) includes selecting a ferromagnetic layer material with a face centered cubic structure.

26. The method as in claim 24 or 25, wherein said step of selecting a spacer with a face centered cubic structure includes the step of selecting said spacer from a group comprising Cu, Ag, Au, Pt, Pd, Cu₃Pt, CuPt, Cu₃Au, CuAu, AgPt₃, Crlr₃, Cr₂Pt, AlCu₃ and Al₂Cu.

27. The method as in any one of claims 24 to 26, wherein said step of selecting a ferromagnetic layer with a face centered cubic structure includes selecting said ferromagnetic layer from the groups comprising NiFe(80:20), Ni₃Fe, Ni₃Mn, Fe₄Mn, FePd, Fe_{1-y} Au_{y}, Co_{1-z} Au_{z}, where y is the atomic fraction with a value between 0.30 and 0.70, and z is the atomic fraction with a value between 0.10 and 0.50; and Fe₁₋ᵥ Crᵥ, Fe_{1-w} V_{w}, ternary FeCrV systems, where u is the atomic fraction with a value between 0.40 and 0.70, and w is the atomic fraction with a value between 0.25 and 0.35.

28. The method as in any one of claims 24 to 27, wherein said step of selecting said substrate includes selecting a substrate material with a base centered cubic structure;
wherein said step of selecting said single crystal spacer includes selecting a spacer material with a base centered cubic structure; and
wherein said step of selecting said single crystal ferromagnetic layers (FM1, FM2) includes selecting a ferromagnetic layer material with a base centered cubic structure.

29. The method as in claim 28, wherein said step of selecting a conductive spacer (12) with a base centered cubic structure includes the step of selecting Cr.

30. The method as in claim 28, wherein said step of selecting a ferromagnetic layer with a base centered cubic structure includes the step of selecting said ferromagnetic layer from the group comprising Cr, Fe, V, Mo, W, Nb and Ta.

31. The method of any one of claims 24 to 30, wherein said step of substantially matching includes the step of minimizing the difference between said first and second electronegativities as in the following equation:$\text{|Δχ| = χ (FM) - χ (spacer) ≈ 0}$

32. A method of optimizing the interfacial properties of a data storage device comprising the steps of:
selecting a substrate having a defined crystallographic structure;
selecting an electrically conductive, polycrystalline spacer having a plurality of individual crystallographic faces, each of said faces having an electronegativity, said spacer defining an average electronegativity; and
selecting a polycrystalline ferromagnetic layer having a plurality of individual crystallographic faces corresponding to said crystallographic faces of said spacer, each of said faces having an electronegativity, said ferromagnetic layer defining an average electronegativity;
wherein said selecting steps provide for matching said electronegativity of an individual crystallographic face of said spacer with said electronegativity of a corresponding individual crystallographic face of said ferromagnetic layer.

33. A method of optimizing the interfacial properties of a data storage device comprising the steps of:
selecting a substrate having a predetermined crystallographic structure;
selecting an electrically conductive, polycrystalline spacer having a plurality of individual crystallographic faces, each of said faces having an electronegativity, said spacer defining an average electronegativity; and
selecting a polycrystalline ferromagnetic layer having a plurality of individual crystallographic faces corresponding to said crystallographic faces of said spacer, each of said faces having an electronegativity, said ferromagnetic layer defining an average electronegativity;
wherein said selecting steps provide for matching said average electronegativity of said spacer with said average electronegativity of said ferromagnetic layer.

34. A method of optimizing the interfacial properties of a data storage device comprising the steps of:
selecting a substrate having a predetermined crystallographic structure;
selecting at least one electrically conductive, single crystal spacer having a crystallographic structure similar to said substrate crystallographic structure and having a first work function;
selecting ferromagnetic, single crystal layers having a crystallographic structure similar to said substrate crystallographic structure and having a second work function; and
wherein said selecting steps include the step of substantially matching said first and second work functions.

35. A method of optimizing the interfacial properties of a data storage device comprising the steps of:
selecting a substrate having a defined crystallographic structure;
selecting an electrically conductive, polycrystalline spacer having a plurality of individual crystallographic faces, each of said faces having a work function, said spacer defining an average work function; and
selecting a polycrystalline ferromagnetic layer having a plurality of individual crystallographic faces corresponding to said crystallographic faces of said spacer, each of said faces having a work function, said ferromagnetic layer defining an average work function;
wherein said selecting steps include matching said average work function of said spacer with said average work function of said ferromagnetic layer.

36. A data storage device comprising:
a substrate having a defined crystallographic structure;
at least one electrically conductive, single crystal spacer having a crystallographic structure similar to said substrate crystallographic structure and having a first electronegativity; and
ferromagnetic, single crystal layers having a crystallographic structure similar to said substrate crystallographic structure and having a second electronegativity; and
wherein said electrically conductive spacer (12) and said ferromagnetic layers (FM1, FM2) are selected so that said first and second electronegativities and are matched for optimizing the interfacial properties of the data storage device.

37. A data storage device comprising in combination:
a substrate having a predetermined crystallographic structure;
an electrically conductive, polycrystalline spacer having a plurality of individual crystallographic faces, each of said faces having an electronegativity, said spacer defining an average electronegativity; and
a polycrystalline ferromagnetic layer having a plurality of individual crystallographic faces corresponding to said crystallographic faces of said spacer, each of said faces having an electronegativity, said ferromagnetic layer defining an average electronegativity;
wherein said spacer and said ferromagnetic layer are selected so that said average electronegativity of said spacer matches said average electronegativity of said ferromagnetic layer for optimizing the interfacial properties of the data storage device.

38. A data storage device comprising:
a substrate having a predetermined crystallographic structure;
an electrically conductive, polycrystalline spacer having a plurality of individual crystallographic faces, each of said faces of said spacer having an electronegativity, said spacer defining an average electronegativity; and
a polycrystalline ferromagnetic layer having a plurality of individual crystallographic faces corresponding to said crystallographic faces of said spacer, each of said faces of said polycrystalline ferromagnetic layer having an electronegativity, said ferromagnetic layer defining an average electronegativity; wherein said spacer and said ferromagnetic layer are selected so that the electronegativity of an individual crystallographic face of said spacer matches the electronegativity of an individual crystallographic face of said ferromagnetic layer for optimizing the interfacial properties of the data storage device.

39. The data storage device as in claim 37 wherein said plurality of individual crystallographic faces of said spacer include three faces: 111, 110 and 100, having individual electronegativities χ₁₁₁, χ₁₀₀, and χ₁₁₀, respectively; and
wherein said average electronegativity of said spacer is defined by the following equation:${\text{χ(average- spacer) = 1/3 (χ}}_{\text{111}} {\text{+ χ}}_{\text{100}} {\text{+ χ}}_{\text{110}} \text{).}$

40. The data storage device as in claim 37 wherein said plurality of individual crystallographic faces of said ferromagnetic layer includes three faces: 111, 110 and 100, having individual electronegativities χ₁₁₁, χ₁₀₀, and χ₁₁₀, respectively; and
wherein said average electronegativity of said ferromagnetic layer is defined by the following equation:${\text{χ(average- FM) = 1/3 (χ}}_{\text{111}} {\text{+ χ}}_{\text{100}} {\text{+ χ}}_{\text{110}} \text{).}$

41. The data storage device as in claim 36 including a spin valve sensor formed of said substrate, said electrically conductive, single crystal spacer, and said ferromagnetic layers (FM1, FM2).

42. The data storage device as in claim 16 including a giant magnetorsistance sensor (20) formed of said substrate, said electrically conductive, single crystal spacer, and said ferromagnetic layers (FM1, FM2).

43. The method as in claim 1, wherein at least one of said ferromagnetic layers (FM1, FM2) is formed with said first material and said conductive spacer (12) is formed with said second material.

44. The method as in claim 1, wherein said ferromagnetic layers (FM1, FM2) comprise a plurality of layers having different electronegativities.

45. The method as in claim 1, wherein said conductive spacer (12) comprises a plurality of spacers (12) having different electronegativities.

46. The method as in claim 45, wherein said sensor is a giant magnetorsistance sensor (20).

47. A data storage device comprising in combination:
a substrate;
electrically conductive spacer (12) means formed on said substrate, said spacer having a first electronegativity; and
ferromagnetic layer means formed adjacent to said spacer means (12) and having a second electronegativity;
wherein a magnetoresistive response characteristic (%ΔR/R) of the data storage device is optimized by correlating said first and second electronegativities to %ΔR/R as follows:${\text{%ΔR/R ≅ A - B (|Δχ|)}}^{\text{½}} \text{,}$ where A and B are constant values and |Δχ| is the absolute value of the difference between said first and second electronegativities.

48. The data storage device as in claim 47, wherein said ferromagnetic layer means constitutes a plurality of ferromagnetic layers (FM1, FM2); and said conductive spacer (12) means comprises a number of spacer layers interposed between said ferromagnetic layers (FM1, FM2); and
wherein the electronegativities of adjacent spacers (12) and ferromagnetic layers (FM1, FM2) are matched.

49. A method of optimizing the magnetoresistive response (%ΔR/R) of a data storage device, comprising the steps of:
selecting at least one electrically conductive spacer (12) having at least a first electronegativity; and
selecting ferromagnetic layers (FM1, FM2) having at least a second electronegativity;
wherein said selecting steps include correlating said first and second electronegativities for optimizing %ΔR/R in accordance with the following equation:${\text{%ΔR/R ≅ A - B (|Δχ|)}}^{\text{½}} \text{,}$ where A and B are constant values and |Δχ| is the absolute value of the difference between said first and second electronegativities.

50. The method according to claim 49, wherein said step of correlating includes the step of optimizing %ΔR/R in view of the following relationship:${\text{%ΔR/R ≅ A - 2A (|Δχ|)}}^{\text{½}} \text{.}$

51. The method according to claim 50, wherein the data storage device includes a spin valve sensor, including the step of setting the constant value A equal to 35.20.

52. The method according to claim 50, wherein the data storage device includes a giant magnetorsistance sensor (20) having a first peak, including the step of setting the constant value A equal to 300 for said first peak.

53. The method according to claim 50, wherein the data storage device includes a giant magnetorsistance sensor (20) having first and second peaks, including the step of setting the constant value A equal to 110 for said second peak.

54. The method according to claim 50, wherein the data storage device includes a giant magnetorsistance sensor (20) having first, second and third peaks, including the step of setting the constant value A equal to 45 for said third peak.
